# FASCICULE DE BREVET EUROPEEN

(11) **EP 2 826 090 B1**
(45) Date de publication et mention de la délivrance du brevet: **31.01.2018**
(21) Numéro de dépôt: 13709209.4
(22) Date de dépôt: 14.03.2013
(51) Int. Cl.: H01M 8/04858, H01M 8/04537, H01M 8/04664, G01R 31/36

(54) **PILE COMPRENANT UNE PLURALITÉ DE CELLULES ÉLECTROCHIMIQUES ET, POUR CHAQUE CELLULE, UN DISPOSITIF DE CONTRÔLE DE LA TENSION AUX BORNES DE LADITE CELLULE**
BATTERIE MIT EINER MEHRZAHL VON BATTERIEZELLEN UND EINER VORRICHTUNG FÜR JEDE ZELLE ZUR STEUERUNG DER SPANNUNG ZWISCHEN DEN KLEMMEN DIESER ZELLE
BATTERY COMPRISING A PLURALITY OF ELECTROCHEMICAL CELLS AND, FOR EACH CELL, A DEVICE FOR CONTROLLING THE VOLTAGE ACROSS THE TERMINALS OF SAID CELL

(30) Priorité: 14.03.2012 FR 1252303
(43) Date de publication de la demande: 21.01.2015
(73) Titulaire: Areva Stockage d'Energie, 13547 Aix-en-Provence (FR)
(72) Inventeur: PHLIPPOTEAU, Vincent, 13090 Aix en Provence (FR)
(74) Mandataire: Lavoix
(86) Numéro de dépôt international: PCT/EP2013/055259
(87) Numéro de publication internationale: WO 2013/135825

(56) Documents cités:
- EP-A1- 1 323 204
- EP-A2- 0 982 788
- US-B1- 6 628 120

## Description

La présente invention concerne une pile, du type comprenant une pluralité de cellules électrochimiques, raccordées en série les unes aux autres et adaptées pour générer chacune un courant électrique à partir d'une réaction d'oxydoréduction entre un fluide oxydant et un fluide réducteur et, pour chaque cellule électrochimique, un dispositif de contrôle de la tension aux bornes de ladite cellule.

On connaît les cellules électrochimiques permettant de produire de l'électricité par réaction d'oxydoréduction entre un fluide oxydant et un fluide réducteur. Notamment, on connaît les cellules de pile à combustible permettant de produire de l'électricité par réaction d'oxydoréduction entre un combustible, comprenant de l'hydrogène, et un comburant, comprenant de l'oxygène. Le combustible est injecté dans un compartiment anodique et le comburant est injecté dans un compartiment cathodique, une couche d'électrolyte assurant l'étanchéité entre ces deux compartiments, en permettant les échanges d'ions. En raison de ces échanges d'ions, l'hydrogène contenu dans le combustible peut réagir avec l'oxygène contenu dans le comburant pour donner de l'eau, en générant des électrons à l'anode. Il s'ensuit, lors du fonctionnement de la pile à combustible, l'établissement d'une différence de potentiel entre les deux côtés de l'électrolyte, cette différence de potentiel pouvant être exploitée pour créer un courant électrique.

Cependant, les différences de potentiel s'établissant au sein d'une cellule de pile à combustible restent faibles, de l'ordre de 0,6 à 1,0V. Aussi, pour obtenir une tension de sortie exploitable, les cellules sont le plus souvent empilées et raccordées électriquement en série les unes autres, au sein de ce qui est couramment appelé une pile à combustible.

Cependant, à l'intérieur d'un tel empilement, il est important de contrôler le fonctionnement correct de chaque cellule indépendamment du fonctionnement des autres cellules. Un tel contrôle individuel des cellules permet en effet de détecter au plus tôt un éventuel défaut, et d'identifier facilement la cellule défectueuse pour la remplacer.

EP 1 323 204 propose ainsi un dispositif de contrôle individuel de la tension des cellules d'une pile à combustible. Ce dispositif de contrôle comprend, pour chaque cellule de la pile, une résistance et un optocoupleur raccordés en série aux bornes de la cellule. Un signal de sortie de chaque optocoupleur est adapté pour s'établir à une tension positive ou négative selon la tension aux bornes de l'entrée de l'optocoupleur est supérieure ou inférieure à sa tension seuil, et pour être transmis à une unité d'interprétation qui envoie un signal de dysfonctionnement lorsque l'un des signaux de sortie a une tension négative.

Ce dispositif de contrôle a l'avantage d'être économique. Toutefois, il a été observé qu'il signalait des dysfonctionnements de manière intempestive, alors même que toutes les cellules de la pile à combustible fonctionnaient correctement.

Le document US6628120 divulgue un circuit de mesure de de la tension des cellules d'une pile à combustible. Un objectif de l'invention est de proposer une solution peu coûteuse et fiable de contrôle de la tension aux bornes de chaque cellule électrochimique d'une pile.

A cet effet, l'invention a pour objet une pile du type précité, comprenant un dispositif régulateur de tension, raccordé électriquement à ladite cellule de façon à ce que le dispositif de contrôle mesure la tension aux bornes de la cellule augmentée d'une tension de décalage aux bornes du dispositif régulateur.

Dans des modes de réalisation préférés de l'invention, la pile présente en outre une ou plusieurs des caractéristiques suivantes, prise(s) isolément ou suivant toute(s) combinaison(s) techniquement possible(s) :
- la tension de décalage est fixe ;
- le dispositif régulateur est un dispositif passif, tel qu'une une diode ;
- le dispositif régulateur est raccordé électriquement, par une première borne, à une borne d'une cellule consécutive de la pile, commune avec la cellule dont est mesurée la tension, et, par une deuxième borne, à l'autre borne de ladite cellule consécutive ;
- la première borne du dispositif régulateur est en liaison électrique directe avec la borne commune à la cellule dont est mesurée la tension et à la cellule consécutive ;
- une résistance est intercalée électriquement entre la deuxième borne du dispositif régulateur et la borne de la cellule consécutive à laquelle est raccordée ladite deuxième borne ;
- le dispositif de contrôle comprend une entrée raccordée d'une part à une borne de la cellule dont est mesurée la tension, et d'autre part à la deuxième borne du dispositif régulateur ;
- le dispositif de contrôle est un élément optique actif ;
- le dispositif de contrôle comprend une sortie pour la construction d'une image de la tension mesurée, les sorties d'au moins deux des dispositifs de contrôle étant raccordées électriquement en série les unes aux autres ;
- le dispositif de contrôle comprend une sortie pour la construction d'une image de la tension mesurée, les sorties d'au moins deux des dispositifs de contrôle étant raccordées électriquement en parallèle les unes aux autres ;
- elle est une pile à combustible.

D'autres caractéristiques et avantages de l'invention apparaîtront à la lecture de la description qui va suivre, donnée uniquement à titre d'exemple et faite en se référant aux dessins annexés, dans lesquels :
- la Figure 1 est une vue schématique en coupe d'une cellule électrochimique d'une pile selon l'invention,
- la Figure 2 est une vue schématique d'un premier détail d'un circuit électrique pour le contrôle de la tension de chaque cellule de la pile selon l'invention,
- la Figure 3 est une vue schématique d'un deuxième détail du circuit électrique pour le contrôle de la tension de chaque cellule de la pile selon l'invention,
- la Figure 4 est une vue schématique du circuit électrique pour le contrôle de la tension de chaque cellule de la pile selon l'invention, dans une première variante, et
- la Figure 5 est une vue schématique du circuit électrique pour le contrôle de la tension de chaque cellule de la pile selon l'invention, dans une deuxième variante.

Dans la suite, il sera fait référence à une pile à combustible selon l'invention, étant entendu que l'invention est également applicable à des piles électriques.

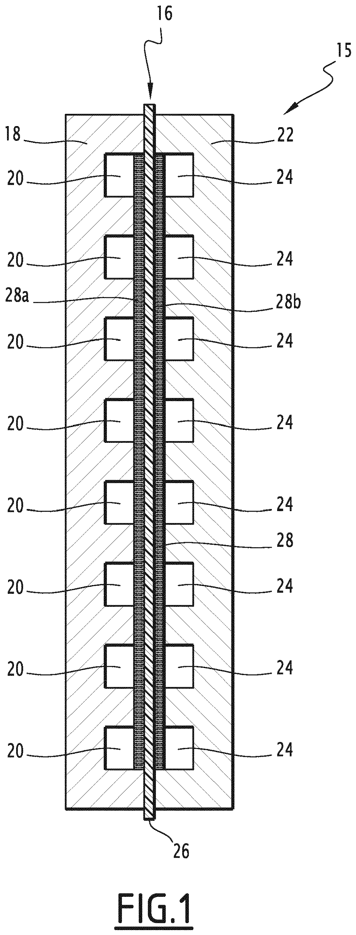

Une cellule 15 de ladite pile à combustible est représentée sur la Figure 1. Elle comprend un assemblage membrane-électrode 16 intercalé entre une plaque anodique 18 et une plaque cathodique 22.

L'assemblage membrane-électrode 16 comprend une membrane 26 d'échange d'ions prise en sandwich entre une anode 28a et une cathode 28b.

La membrane 26 isole électriquement l'anode 28a de la cathode 28b.

La membrane 26 est adaptée pour ne laisser que des ions chargés, de préférence des cations, la traverser. La membrane 26 est généralement une membrane d'échange de protons, adaptée pour ne laisser que des protons la traverser. La membrane 26 est typiquement en matériau polymère.

L'anode 28a et la cathode 28b comprennent chacune un catalyseur, typiquement du platine ou un alliage de platine, pour faciliter la réaction.

La plaque anodique 18 délimite un conduit anodique 20 pour la circulation d'un gaz réducteur le long de l'anode 28a et en contact avec celle-ci. Pour ce faire, la plaque 18 est munie d'au moins un canal ménagé dans la face de la plaque tournée vers l'assemblage membrane-électrode 16 et refermé par ledit assemblage membrane électrode 16. La plaque anodique 18 est formée d'un matériau conducteur électriquement, typiquement du graphite. Le gaz réducteur utilisé est un gaz comprenant du dihydrogène, comme par exemple du dihydrogène pur.

La plaque cathodique 22 délimite un conduit cathodique 24 pour la circulation d'un gaz oxydant le long de la cathode 28b et en contact avec celle-ci. Pour ce faire, la plaque 22 est munie d'au moins un canal ménagé dans la face de la plaque tournée vers l'assemblage membrane-électrode 16 et refermé par ledit assemblage membrane électrode 16. La plaque cathodique 22 est formée d'un matériau conducteur électriquement, typiquement du graphite. Le gaz oxydant utilisé est un gaz comprenant du dioxygène, comme par exemple du dioxygène pur, de l'air, ou un mélange reconstitué de dioxygène et d'un gaz neutre, tel que de l'azote ou du dioxyde de carbone.

La membrane 26 sépare les gaz oxydant et réducteur. Elle est disposée entre la plaque anodique 18 et la plaque cathodique 22 de la cellule 15 et isole celles-ci électriquement l'une de l'autre.

L'anode 28a est en contact électrique avec la plaque anodique 18. La cathode 28b est en contact électrique avec la plaque cathodique 22. Lors du fonctionnement de la pile à combustible, il se produit au niveau de l'anode 28a une oxydation du gaz réducteur induisant la génération d'électrons et de protons. Les électrons transitent ensuite via la plaque anodique 18 vers la cathode 28b de la cellule 15, ou vers la cathode d'une autre cellule, pour participer à une réduction du gaz oxydant.

La cellule 15 comprend ainsi deux bornes électriques : une borne électrique négative est constituée par la plaque anodique 18, et une borne électrique positive est constituée par la plaque cathodique 20.

La cellule 15 est empilée avec d'autres cellules similaires, la plaque anodique 18 de chaque cellule étant en contact avec la plaque cathodique 22 de la cellule voisine. Les plaques anodique et cathodique 18, 22 assurent ainsi le transfert des électrons du gaz réducteur circulant dans une cellule vers le gaz oxydant circulant dans une autre cellule. Les plaques anodique 18 et cathodique 22 de deux cellules voisines de l'empilement sont de préférence venues de matière et forment ensemble une plaque bipolaire.

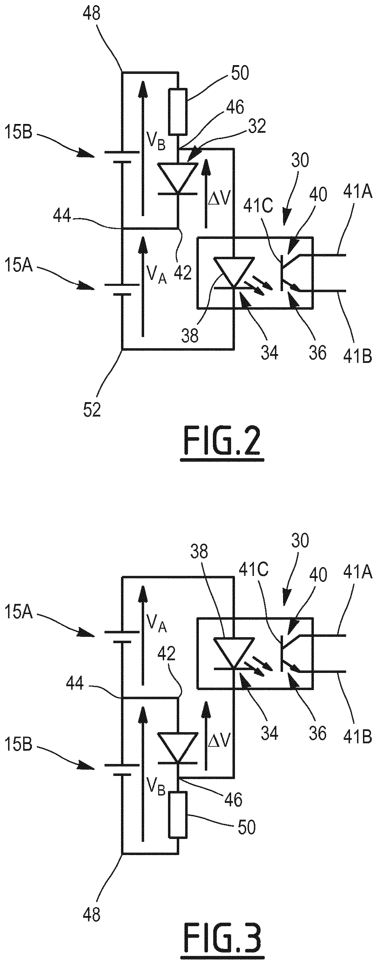

En référence aux Figures 2 et 3, la pile à combustible comprend, pour chaque cellule 15A, un dispositif 30 de contrôle de la tension aux bornes de ladite cellule 15A. Elle comprend en outre dispositif 32 régulateur de tension, agencé de façon à ce que le dispositif de contrôle 30 mesure la tension V_{A} aux bornes de la cellule 15A, augmenté d'une tension de décalage ΔV fixe.

La tension V_{A} est typiquement comprise entre 0,5 et 1,0V, en fonctionnement normal de la cellule 15A. La tension de décalage ΔV est la tension aux bornes du dispositif régulateur 32. De préférence, la tension de décalage ΔV est sensiblement égale 0,3V.

Le dispositif de contrôle 30 est constitué par un dispositif optique actif, typiquement un optocoupleur. Il comprend une entrée 34, raccordée électriquement à la cellule 15A, pour la mesure de sa tension VA, et une sortie 36, pour la construction d'une image de la tension mesurée VA. L'entrée 34 et la sortie 36 sont isolées électriquement.

L'entrée 34 comprend une diode électroluminescente 38, adaptée pour émettre des photons lorsque la tension à ses bornes est supérieure à une tension seuil Vₘᵢₙ. En fonctionnement normal de la cellule 15A, la tension seuil Vₘᵢₙ est inférieure à la somme des tensions V_{A} et ΔV, de sorte que la diode électroluminescente 38 émet des photons. La tension seuil Vₘᵢₙ est typiquement comprise entre 0,8 et 1,2V.

La sortie 36 comprend un phototransistor 40 adapté pour être en configuration fermée, c'est-à-dire raccordant électriquement son collecteur 41A et son émetteur 41B l'un à l'autre, lorsque sa base 41C reçoit des photons, et pour être en configuration ouverte, c'est-à-dire isolant électriquement son collecteur 41A et son émetteur 41B l'un de l'autre, lorsque sa base 41C ne reçoit pas de photons.

Le phototransistor 40 est couplé optiquement à la diode électroluminescente 38. En d'autres termes, la diode électroluminescente 38 et le phototransistor 40 sont agencés de façon à ce que les photons émis par la diode 38 parviennent à la base 41C du phototransistor 40. Le passage du phototransistor 40 de sa configuration ouverte à sa configuration fermée est ainsi commandé par l'état de la diode électroluminescente 38.

Le dispositif régulateur 32 est un dispositif électrique passif. En particulier, le dispositif régulateur 32 est une diode, typiquement une diode Shottky, avantageuse parce que peu coûteuse et donnant une tension de décalage fixe et facilement maîtrisable. La diode est orientée de manière à laisser passer les courants des zones de potentiel haut aux zones de potentiel inférieur. Ainsi, en fonctionnement normal, la tension aux bornes du dispositif régulateur 32, qui est également la tension de décalage ΔV, est égale à la tension seuil de la diode.

Le dispositif régulateur 32 comprend une première borne 42, raccordée électriquement à une borne 44 d'une cellule 15B de l'empilement consécutive à la cellule 15A. En d'autres termes, la première borne 42 est raccordée à la plaque bipolaire formant la séparation entre les cellules 15A et 15B. La première borne 42 est en liaison électrique directe avec la borne 44 commune aux cellules 15A, 15B, c'est-à-dire qu'il n'y a pas de composant électrique interposé les bornes 42 et 44.

Le dispositif régulateur 32 comprend également une deuxième borne 46, raccordée électriquement à l'autre borne 48 de la cellule consécutive 15B. En d'autres termes, la deuxième borne 46 est raccordée électriquement à la plaque 18, 22 de la cellule 15B opposée à la face de contact de la cellule 15B avec la cellule 15A. Une résistance 50 est intercalée entre la deuxième borne 46 et la borne 48, pour limiter l'intensité du courant traversant le dispositif régulateur 32.

L'entrée 34 du dispositif de contrôle 30 est raccordée d'une part à la deuxième borne 46 du dispositif régulateur 32, et d'autre part à la borne 52 de la cellule 15A autre que la borne commune 44.

Dans l'exemple représenté sur la Figure 2, la borne commune 44 est la borne de la cellule 15A ayant le potentiel le plus élevé. La cellule consécutive 15B est alors une cellule supérieure de l'empilement. Le dispositif régulateur 32 est orienté de façon à ce que sa borne 42 soit sa borne de potentiel le plus faible. Ainsi, la tension aux bornes de l'entrée 34 est égale à la somme des tensions V_{A} et ΔV.

Dans l'exemple représenté sur la Figure 3, la borne commune 44 est la borne de la cellule 15A ayant le potentiel le plus faible. La cellule consécutive 15B est alors une cellule inférieure de l'empilement. Le dispositif régulateur 32 est orienté de façon à ce que sa borne 42 soit sa borne de potentiel le plus élevé. Ainsi, la tension aux bornes de l'entrée 34 est égale à la somme des tensions V_{A} et ΔV.

Le dispositif de contrôle 30 mesurant ainsi la tension VA de la cellule 15A augmentée de la tension de décalage ΔV, la tension VA peut varier sur une plage plus large avant que la tension aux bornes de l'entrée 34 du dispositif de contrôle 30 ne passe sous la tension seuil Vₘᵢₙ. Les détections intempestives de dysfonctionnement de la cellule 15A sont ainsi évitées.

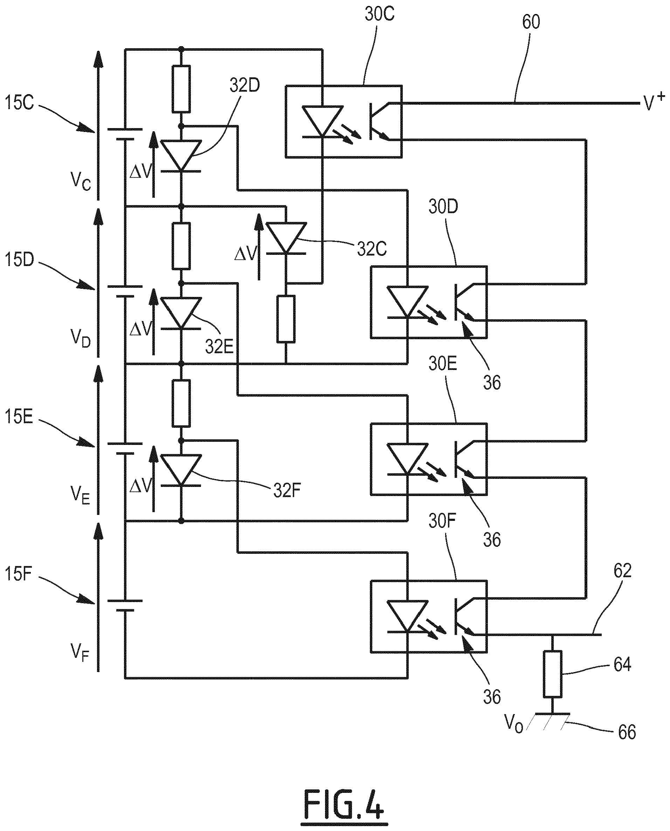

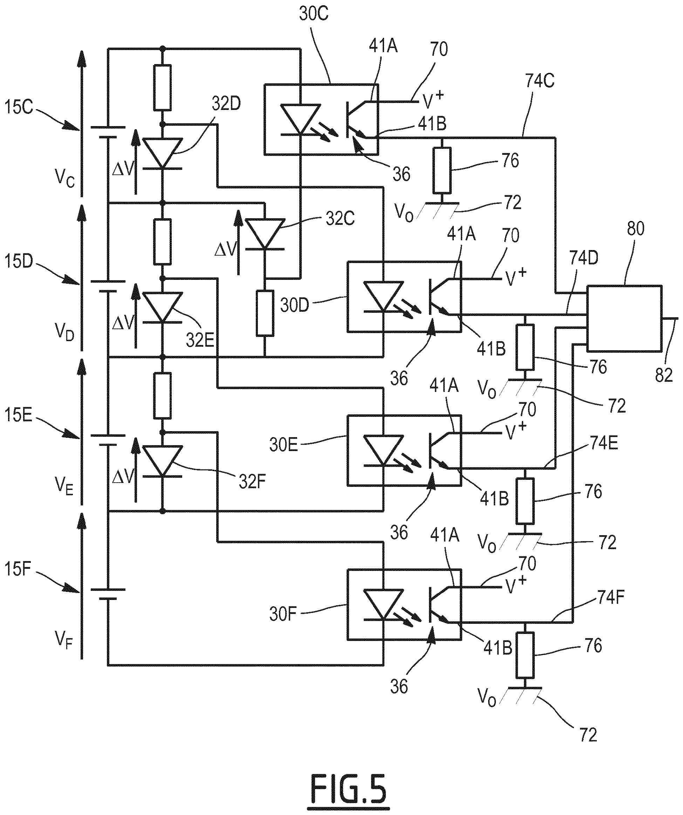

En référence aux Figures 4 et 5, la pile à combustible comprend quatre cellules 15C, 15D, 15E, 15F raccordées en série les unes aux autres. On notera que ce nombre de cellules n'est donné qu'à titre d'exemple et que, dans des variantes de l'invention, la pile comprend un autre nombre de cellules, ce nombre étant, selon les variantes, supérieur ou inférieur à quatre.

La tension V_{C}, V_{D}, V_{E}, V_{F} de chaque cellule 15C, 15D, 15E, 15F est mesurée par un dispositif de contrôle, respectivement 30C, 30D, 30E, 30F. De même que pour la cellule 15A représentée sur les Figures 2 et 3, un dispositif régulateur, respectivement 32C, 32D, 32E, 32F, est fourni pour chaque cellule 15C, 15D, 15E, 15F, de façon à ce que le dispositif de contrôle 30C, 30D, 30E, 30F associé mesure la tension V_{C}, V_{D}, V_{E}, V_{F} augmentée d'une tension de décalage ΔV.

Pour chacune des cellules 15D, 15E, 15F, la cellule consécutive aux bornes de laquelle est raccordé le dispositif régulateur 32D, 32E, 32F est constituée par la cellule consécutive supérieure, respectivement 15C, 15D, 15E. Pour la cellule 15C, la cellule consécutive aux bornes de laquelle est raccordé le dispositif régulateur 32C est constituée par la cellule consécutive inférieure 15D.

Dans la variante présentée sur la Figure 4, les sorties 36 des dispositifs de contrôle 30C, 30D, 30E, 30F sont raccordées en série les unes aux autres, entre une ligne 60 de potentiel positif V⁺ (typiquement 5 volts) et une ligne 62 de sortie. Une résistance 64 est interposée électriquement entre la ligne 62 et une ligne 66 de potentiel de référence V₀.

Ainsi, tant que tous les phototransistors 40 des dispositifs de contrôle 30C, 30D, 30E, 30F sont fermés, le potentiel de la ligne de sortie 62 est égal au potentiel positif V⁺. Si en revanche le potentiel de la ligne de sortie 62 passe au potentiel de référence V₀, c'est le signe que l'un des phototransistors 40 s'est ouvert, et donc que l'une des cellules 15C, 15D, 15E, 15F connaît un dysfonctionnement.

Dans la variante présentée sur la Figure 5, les sorties 36 des dispositifs de contrôle 30C, 30D, 30E, 30F sont raccordées en parallèle les unes aux autres, entre une ligne 70 de potentiel positif V⁺ (typiquement 5 volts) et une ligne 72 de potentiel de référence V₀. En particulier, chaque collecteur 41A est raccordé électriquement à la ligne 70, et chaque émetteur 41B est raccordé électriquement à la ligne 72. En outre, une ligne de sortie 74C, 74D, 74E, 74F prolonge chaque émetteur 41B. Enfin, une résistance 76 est intercalée entre chaque émetteur 41B et la ligne 72.

De préférence, un multiplexeur 80 est prévu pour combiner les signaux des différentes lignes de sortie 74C, 74D, 74E, 74F et les transmettre via une unique ligne 82.

Ainsi, tant que le phototransistor 40 du dispositif de contrôle 30C, 30D, 30E, 30F associé à une ligne de sortie, respectivement 74C, 74D, 74E, 74F, est fermé, le potentiel de ladite ligne de sortie 74C, 74D, 74E, 74F est égal au potentiel positif V⁺. Si en revanche le potentiel de la ligne de sortie 74C, 74D, 74E, 74F passe au potentiel de référence V₀, c'est le signe que le phototransistor 40 associé s'est ouvert, et donc que la cellule associée, respectivement 15C, 15D, 15E, 15F, connaît un dysfonctionnement.

Ce mode de réalisation permet un pilotage plus précis de la pile à combustible en apportant une information plus détaillée que dans le mode de réalisation de la Figure 4, pour un coût à peine plus élevé.

Dans une troisième variante de l'invention (non représentée), les sorties 36 d'une première paire de dispositifs de contrôle 30C, 30D, sont raccordées en série l'une à l'autre, et les sorties 36 d'une deuxième paire de dispositifs de contrôle 30E, 30F sont raccordées en série l'une à l'autre, entre une ligne au potentiel positif V⁺ et une ligne de sortie. Les lignes de sortie sont raccordées en parallèle les unes aux autres à un multiplexeur, prévu pour combiner les signaux des différentes lignes de sortie.

Ainsi, tant que les phototransistors 40 des dispositifs de contrôle 30C, 30D, 30E, 30F associés à une ligne de sortie est fermé, le potentiel de ladite ligne de sortie est égal au potentiel positif. Si en revanche le potentiel de la ligne de sortie passe au potentiel de référence V₀, c'est le signe que l'un des phototransistors 40 associés s'est ouvert, et donc que l'une des cellules associées 15C, 15D, 15E, 15F connaît un dysfonctionnement.

Il est donc possible d'identifier des dysfonctionnements au niveau de paires de cellules, sans toutefois pouvoir identifier un dysfonctionnement de chaque cellule indépendamment des autres, comme dans le mode de réalisation de la Figure 5. Cette troisième variante est avantageuse dans le cas où la pile comprend un grand nombre de cellules.

On notera que, dans l'exemple de troisième variante donné ci-dessus, les dispositifs de contrôle 30 sont groupés par paires, mais que les dispositifs de contrôle 30 pourraient être groupés par lots comprenant chacun plus de deux dispositifs de contrôle 30, le nombre de dispositifs de contrôle 30 au sein d'un même lot pouvant varier d'un lot à l'autre.

Grâce à l'invention, il est donc possible de contrôler que la tension aux bornes de chaque cellule de la pile reste dans la plage de valeur tolérée, de façon fiable et à moindre coût.

## Revendications

1. Pile comprenant une pluralité de cellules électrochimiques (15, 15A, 15B, 15C, 15D, 15E, 15F), raccordées en série les unes aux autres et adaptées pour générer chacune un courant électrique à partir d'une réaction d'oxydoréduction entre un fluide oxydant et un fluide réducteur et, pour chaque cellule électrochimique (15, 15A, 15B, 15C, 15D, 15E, 15F), un dispositif (30, 30C, 30D, 30E, 30F) de contrôle de la tension aux bornes de ladite cellule (15, 15A, 15B, 15C, 15D, 15E, 15F), **caractérisée en ce qu'**elle comprend un dispositif (32, 32C, 32D, 32E, 32F) régulateur de tension, raccordé électriquement à ladite cellule (15, 15A, 15B, 15C, 15D, 15E, 15F) de façon à ce que le dispositif de contrôle (30, 30C, 30D, 30E, 30F) mesure la tension aux bornes de la cellule (15, 15A, 15B, 15C, 15D, 15E, 15F), augmentée d'une tension de décalage (ΔV) aux bornes du dispositif régulateur (32, 32C, 32D, 32E, 32F).

2. Pile selon la revendication 1, **caractérisée en ce que** la tension de décalage (ΔV) est fixe.

3. Pile selon la revendication 1 ou 2, **caractérisée en ce que** le dispositif régulateur (32, 32C, 32D, 32E, 32F) est un dispositif passif, tel qu'une une diode.

4. Pile selon l'une quelconque des revendications précédentes, **caractérisée en ce que** le dispositif régulateur (32, 32C, 32D, 32E, 32F) est raccordé électriquement, par une première borne (42), à une borne (44) d'une cellule consécutive (15B, 15C, 15D, 15E, 15F) de la pile, commune avec la cellule (15A, 15C, 15D, 15E, 15F) dont est mesurée la tension, et, par une deuxième borne (46), à l'autre borne (48) de ladite cellule consécutive (15B, 15C, 15D, 15E, 15F).

5. Pile selon la revendication 4, **caractérisée en ce que** la première borne (42) du dispositif régulateur (32, 32C, 32D, 32E, 32F) est en liaison électrique directe avec la borne (44) commune à la cellule (15A, 15C, 15D, 15E, 15F) dont est mesurée la tension et à la cellule consécutive (15B, 15C, 15D, 15E, 15F).

6. Pile selon la revendication 4 ou 5, **caractérisée en ce qu'**une résistance (50) est intercalée électriquement entre la deuxième borne (46) du dispositif régulateur (32, 32C, 32D, 32E, 32F) et la borne (48) de la cellule consécutive (15B, 15C, 15D, 15E, 15F) à laquelle est raccordée ladite deuxième borne (46).

7. Pile selon l'une quelconque des revendications 4 à 6, **caractérisée en ce que** le dispositif de contrôle (30, 30C, 30D, 30E, 30F) comprend une entrée (34) raccordée d'une part à une borne (52) de la cellule (15A, 15C, 15D, 15E, 15F) dont est mesurée la tension, et d'autre part à la deuxième borne (46) du dispositif régulateur (32, 32C, 32D, 32E, 32F).

8. Pile selon l'une quelconque des revendications précédentes, **caractérisée en ce que** le dispositif de contrôle (30, 30C, 30D, 30E, 30F) est un élément optique actif.

9. Pile selon l'une quelconque des revendications précédentes, **caractérisée en ce que** le dispositif de contrôle (30, 30C, 30D, 30E, 30F) comprend une sortie (36) pour la construction d'une image de la tension mesurée, les sorties (36) d'au moins deux des dispositifs de contrôle (30, 30C, 30D, 30E, 30F) étant raccordées électriquement en série les unes aux autres.

10. Pile selon l'une quelconque des revendications 1 à 8, **caractérisée en ce que** le dispositif de contrôle (30, 30C, 30D, 30E, 30F) comprend une sortie (36) pour la construction d'une image de la tension mesurée, les sorties (36) d'au moins deux des dispositifs de contrôle (30, 30C, 30D, 30E, 30F) étant raccordées électriquement en parallèle les unes aux autres.

11. Pile selon l'une quelconques des revendications précédentes, **caractérisée en ce qu'**elle est une pile à combustible.

## Patentansprüche

1. Batterie, eine Mehrzahl von elektrochemischen Zellen (15, 15A, 15B, 15C, 15D, 15E, 15F), die in Reihe miteinander geschaltet sind und geeignet sind, jeweils einen elektrischen Strom aus einer Oxidations-Reduktionsreaktion zwischen einem oxidierenden Fluid und einem reduzierenden Fluid zu erzeugen, und für jede elektrochemische Zelle (15, 15A, 15B, 15C, 15D, 15E, 15F) eine Vorrichtung (30, 30C, 30D, 30E, 30F) zur Steuerung der Spannung an den Klemmen der Zelle (15, 15A, 15B, 15C, 15D, 15E, 15F) umfassend, **dadurch gekennzeichnet, dass** sie eine Vorrichtung (32, 32C, 32D, 32E, 32F) zum Regeln der Spannung umfasst, die elektrisch mit der Zelle (15, 15A, 15B, 15C, 15D, 15E, 15F) derart verbunden ist, dass die Steuervorrichtung (30, 30C, 30D, 30E, 30F) die Spannung an den Klemmen der Zelle (15, 15A, 15B, 15C, 15D, 15E, 15F), erhöht um eine Offset-Spannung (ΔV) an den Klemmen der Regelvorrichtung (32, 32C, 32D, 32E, 32F) misst.

2. Batterie nach Anspruch 1, **dadurch gekennzeichnet, dass** die Offset-spannung (ΔV) fest ist.

3. Batterie nach Anspruch 1 oder 2, **dadurch gekennzeichnet, dass** die Regelvorrichtung (32, 32C, 32D, 32E, 32F) eine passive Vorrichtung, wie eine Diode ist.

4. Batterie nach einem beliebigen der vorhergehenden Ansprüche, **dadurch gekennzeichnet, dass** die Regelvorrichtung (32, 32C, 32D, 32E, 32F) über eine erste Klemme (42) elektrisch an eine Klemme (44) einer folgenden Zelle (15B, 15C, 15D, 15E, 15F) der Batterie gemeinsam mit der Zelle (15A, 15B, 15C, 15D, 15E, 15F), an der die Spannung gemessen wird, und über eine zweite Klemme (46) an die andere Klemme (48) der folgenden Zelle (15B, 15C, 15D, 15E, 15F) angeschlossen ist.

5. Batterie nach Anspruch 4, **dadurch gekennzeichnet, dass** die erste Klemme (42) der Regelvorrichtung (32, 32C, 32D, 32E, 32F) in direkter elektrischer Verbindung mit der Klemme (44) ist, die der Zelle (15A, 15B, 15C, 15D, 15E, 15F), an der die Spannung gemessen wird, und der folgenden Zelle (15B, 15C, 15D, 15E, 15F) gemeinsam ist.

6. Batterie nach Anspruch 4 oder 5, **dadurch gekennzeichnet, dass** ein Widerstand (50) elektrisch zwischen die zweite Klemme (46) der Regelvorrichtung (32, 32C, 32D, 32E, 32F) und die Klemme (48) der folgenden Zelle (15B, 15C, 15D, 15E, 15F), mit der die zweite Klemme (46) verbunden ist, geschaltet ist.

7. Batterie nach einem beliebigen der Ansprüche 4 bis 6, **dadurch gekennzeichnet, dass** die Steuervorrichtung (30, 30C, 30D, 30E, 30F) einen Eingang (34) umfasst, der einerseits an einer Klemme (52) der Zelle (15A, 15C, 15D, 15E, 15F), an der die Spannung gemessen wird, und andererseits an die zweite Klemme (46) der Regelvorrichtung (32, 32C, 32D, 32E, 32F) angeschlossen ist.

8. Batterie nach einem beliebigen der vorhergehenden Ansprüche, **dadurch gekennzeichnet, dass** die Steuervorrichtung (30, 30C, 30D, 30E, 30F) ein aktives optisches Element ist.

9. Batterie nach einem beliebigen der vorhergehenden Ansprüche, **dadurch gekennzeichnet, dass** die Steuervorrichtung (30, 30C, 30D, 30E, 30F) einen Ausgang (36) für den Aufbau eines Bildes der gemessenen Spannung umfasst, wobei die Ausgänge (36) von mindestens zwei der Steuervorrichtungen (30, 30C, 30D, 30E, 30F) elektrisch miteinander in Reihe geschaltet sind.

10. Batterie nach einem beliebigen der Ansprüche 4 bis 8, **dadurch gekennzeichnet, dass** die Steuervorrichtung (30, 30C, 30D, 30E, 30F) einen Ausgang (36) für den Aufbau eines Bildes der gemessenen Spannung umfasst, wobei die Ausgänge (36) von mindestens zwei der Steuervorrichtungen (30, 30C, 30D, 30E, 30F) elektrisch zueinander parallel geschaltet sind.

11. Batterie nach einem beliebigen der vorhergehenden Ansprüche, **dadurch gekennzeichnet, dass** sie eine Brennstoffzelle ist.

## Claims

1. A battery comprising a plurality of electrochemical cells (15, 15A, 15B, 15C, 15D, 15E, 15F), connected in series with each other and adapted for each generating an electric current from an oxidation-reduction reaction between an oxidizing fluid and a reducing fluid, and, for each electrochemical cell (15, 15A, 15B, 15C, 15D, 15E, 15F), a device (30, 30C, 30D, 30E, 30F) for controlling the voltage across the terminals of said cell (15, 15A, 15B, 15C, 15D, 15E, 15F), **characterized in that** it comprises a voltage regulator device (32, 32C, 32D, 32E, 32F), electrically connected to said cell (15, 15A, 15B, 15C, 15D, 15E, 15F) so that the control device (30, 30C, 30D, 30E, 30F) measures the voltage across the terminals of the cell (15, 15A, 15B, 15C, 15D, 15E, 15F), increased by an offset voltage (ΔV) across the terminals of the regulator device (32, 32C, 32D, 32E, 32F).

2. The battery according to claim 1, **characterized in that** the offset voltage (ΔV) is fixed.

3. The battery according to claim 1 or 2, **characterized in that** the regulator device (32, 32C, 32D, 32E, 32F) is a passive device, such as a diode.

4. The battery according to any of the preceding claims, **characterized in that** the regulator device (32, 32C, 32D, 32E, 32F) is electrically connected, through a first terminal (42), to a terminal (44) of a consecutive cell (15B, 15C, 15D, 15E, 15F) of the battery, common with the cell (15A, 15C, 15D, 15E, 15F) whose voltage is measured, and, through a second terminal (46), to the other terminal (48) of said consecutive cell (15B, 15C, 15D, 15E, 15F).

5. The battery according to claim 4, **characterized in that** the first terminal (42) of the regulator device (32, 32C, 32D, 32E, 32F) is in direct electric connection with the terminal (44) common to the cell (15A, 15C, 15D, 15E, 15F) whose voltage is measured and to the consecutive cell (15B, 15C, 15D, 15E, 15F).

6. The battery according to claim 4 or 5, **characterized in that** a resistor (50) is electrically inserted between the second terminal (46) of the regulator device (32, 32C, 32D, 32E, 32F) and the terminal (48) of the consecutive cell (15B, 15C, 15D, 15E, 15F) to which is connected said second terminal (46).

7. The battery according to any of claims 4 to 6, **characterized in that** the control device (30, 30C, 30D, 30E, 30F) comprises an input (34) connected to a terminal (52) of the cell (15A, 15C, 15D, 15E, 15F) whose voltage is measured, on the one hand and to the second terminal (46) of the regulator device (32, 32C, 32D, 32E, 32F) on the other hand.

8. The battery according to any of the preceding claims, **characterized in that** the control device (30, 30C, 30D, 30E, 30F) is an active optical element.

9. The battery according to any of the preceding claims, **characterized in that** the control device (30, 30C, 30D, 30E, 30F) comprises an output (36) for constructing an image of the measured voltage, the outputs (36) of at least two of the control devices (30, 30C, 30D, 30E, 30F) being electrically connected in series with each other.

10. The battery according to any of claims 1 to 8, **characterized in that** the control device (30, 30C, 30D, 30E, 30F) comprises an output (36) for constructing an image of the measured voltage, the outputs (36) of at least two of the control devices (30, 30C, 30D, 30E, 30F) being electrically connected in parallel with each other.

11. The battery according to any of the preceding claims, **characterized in that** it is a fuel cell.
